# FASCICULE DE BREVET EUROPEEN

(11) **EP 1 637 498 B1**
(45) Date de publication et mention de la délivrance du brevet: **30.05.2007**
(21) Numéro de dépôt: 05108509.0
(22) Date de dépôt: 15.09.2005
(51) Int. Cl.: B81B 7/02, B81B 3/00, B81C 1/00

(54) **Transistor MOS à grille déformable**
MOS Transistor mit verformbaren Gate
MOS transistor with deformable gate

(30) Priorité: 16.09.2004 FR 0452070
(43) Date de publication de la demande: 22.03.2006
(73) Titulaire: ST MICROELECTRONICS S.A., 92120 Montrouge (FR); COMMISSARIAT A L'ENERGIE ATOMIQUE, 75752 Paris Cédex 15 (FR)
(72) Inventeur: ANCEY, Pascal, 38420, REVEL (FR); ABELE, Nicolas, 75006, PARIS (FR); CASSET, Fabrice, 38570, TENCIN (FR)
(74) Mandataire: de Beaumont, Michel

(56) Documents cités:
- EP-A- 0 785 437
- FR-A- 2 827 270
- POTT V ET AL: "THE SUSPENDED-GATE MOSFET (SG-MOSFET): A MODELING OUTLOOK FOR THE DESIGN OF RF MEMS SWITCHES AND TUNABLE CAPACITORS" CAS 2001, INTERNATIONAL SEMICONDUCTOR CONFERENCE, 9-13 OCT. 2001, SINAIA, ROMANIA, vol. 1, 2001, pages 137-140, XP001153332 PISCATAWAY, NJ, USA
- NATHANSON H C ET AL: "THE RESONANT GATE TRANSISTOR" IEEE TRANSACTIONS ON ELECTRON DEVICES, IEEE INC. NEW YORK, US, vol. ED-14, no. 3, mars 1967 (1967-03), pages 117-133, XP001040818 ISSN: 0018-9383
- CHOU T-K A ET AL: "FABRICATION OF OUT-OF-PLANE CURVED SURFACES IN SI BY UTILIZING RIE LAG" MEMS 2002. LAS VEGAS, NV, JAN. 20 - 24 2002, IEEE INTERNATIONAL MICRO ELECTRO MECHANICAL SYSTEMS CONFERENCE, vol. CONF. 15, 2002, pages 145-148, XP010577616 NEW YORK, NJ, USA ISBN: 0-7803-7185-2

## Description

### Domaine de l'invention

La présente invention concerne un transistor MOS à grille déformable. Un tel transistor peut notamment être utilisé comme capteur de pression, capteur d'accélération ou comme résonateur. Exposé de l'art antérieur

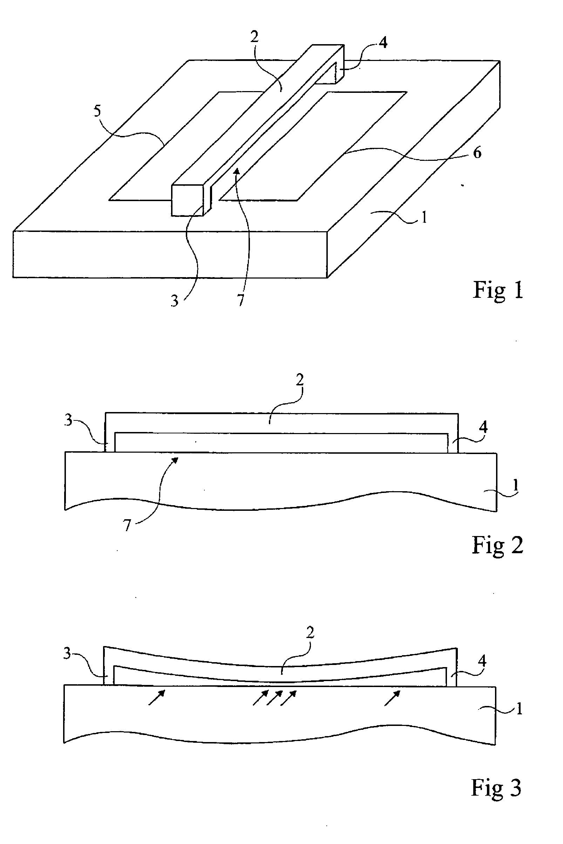

La figure 1 est une vue en perspective d'un transistor MOS à grille déformable connu. Ce type de transistor est décrit dans le brevet WO03/078299 de l'Ecole Polytechnique Fédérale de Lausanne intitulé "PROCESS FOR MANUFACTURING MEMs", publié le 25 septembre 2003. Ce transistor est formé dans et au-dessus d'un substrat semiconducteur 1. Une poutre de grille 2 s'appuie à chaque extrémité sur des piliers 3 et 4 placés sur le substrat 1. Des zones de source/drain 5 et 6 formées dans le substrat 1 sont placées de chaque côté de la poutre 2. La portion de substrat située sous la poutre 2 comprend une zone de canal 7.

Les figures 2 et 3 sont des vues en coupe du transistor de la figure 1 selon l'axe longitudinal de la poutre de grille 2. A l'état de repos, comme cela est représenté en figure 2, la poutre 2 est horizontale. La poutre est susceptible de se déformer sous l'action d'une force mécanique, électrostatique, ou électromagnétique. Lorsque la poutre se déforme, elle se courbe en "arc" comme cela est représenté en figure 3. La partie centrale de la poutre de grille 2 est proche de la zone de canal 7 alors que les extrémités de la poutre sont éloignées de la zone de canal.

La poutre comprend une couche conductrice qui peut être mise à un potentiel déterminé et constitue la grille du transistor MOS ayant pour source et drain les zones 5 et 6 et pour zone de canal la zone 7.

Lorsque la poutre est horizontale, la capacité grille-substrat est faible. Le transistor présente alors une tension de seuil élevée. Plus la poutre se déforme en se rapprochant du substrat, plus la tension de seuil du transistor diminue. En conséquence, pour une polarisation donnée de la grille et des zones de source/drain, plus la poutre de grille 2 est déformée plus le courant traversant le transistor est important. Ainsi, les mouvements de la poutre de grille se traduisent par des variations de courant à travers le transistor.

Cependant, le courant traversant la zone de canal 7 n'est pas uniforme sur l'ensemble de cette zone. La distance entre la poutre 2 à l'état fléchi et la zone de canal 7 étant plus faible dans la partie centrale de la zone de canal que sur l'extérieur de cette zone à proximité des piliers 3 et 4, la densité de courant est maximale au centre de la zone de canal et minimale à proximité des piliers. En conséquence, la majeure partie du courant traversant le transistor passe par la partie centrale du canal. Les parties latérales jouent alors un rôle mineur dans la détection de la déformation de la poutre.

### Résumé de l'invention

Un objet de la présente invention est de prévoir un transistor MOS à grille déformable qui permette de détecter plus finement les mouvements de sa grille.

Un autre objet de la présente invention est de prévoir un procédé de fabrication d'un tel transistor MOS à grille déformable.

Pour atteindre ces objets, la présente invention prévoit un transistor MOS à grille déformable formé dans un substrat semiconducteur, comprenant des zones de source et de drain séparées par une zone de canal s'étendant dans une première direction de la source au drain et dans une deuxième direction perpendiculaire à la première, une poutre conductrice de grille placée au moins au-dessus de la zone de canal s'étendant dans la deuxième direction entre des points d'appui placés sur le substrat de chaque côté de la zone de canal, dans lequel la surface de la zone de canal est creuse et a une forme semblable à celle de la poutre de grille lorsque celle-ci est en déflexion maximale vers la zone de canal.

Selon une variante du transistor décrit ci-dessus, le transistor comprend en outre une couche d'oxyde de grille recouvrant la zone de canal.

Selon une variante du transistor décrit ci-dessus, la poutre est en silicium polycristallin dopé.

Selon une variante du transistor décrit ci-dessus, la poutre est un tricouche de métal, de titane et de nitrure de silicium.

Selon une variante du transistor décrit ci-dessus, les zones de source et de drain ont une forme courbe identique à celle de la zone de canal.

La présente invention prévoit aussi un circuit oscillateur comprenant un transistor à grille déformable tel que décrit précédemment, le transistor étant traversé par un courant qui est fourni à un amplificateur, la sortie de l'amplificateur correspondant à la sortie du circuit étant reliée à la poutre de grille du transistor par l'intermédiaire d'un condensateur, la poutre de grille étant reliée à une tension de polarisation.

La présente invention prévoit en outre un procédé de fabrication d'un transistor à grille déformable comprenant les étapes suivantes : former par implantation dans un substrat des zones de source et de drain séparées par une zone de canal ; déposer une couche de protection sur le substrat ; former une ouverture dans la couche de protection au moins au-dessus de la zone de canal ; effectuer un polissage mécano-chimique de la structure précédemment obtenue, le procédé de gravure du polissage étant tel qu'il grave davantage le substrat que la couche de protection, d'où il résulte qu'un creux est formé dans le substrat sous ladite ouverture ; éliminer la couche de protection ; former une couche d'oxyde de grille sur le substrat ; former une première portion sacrificielle dans ledit creux ; déposer et graver une couche sacrificielle d'où il résulte qu'une deuxième portion sacrificielle recouvre la première portion sacrificielle ; former une poutre conductrice de grille passant au-dessus de la seconde portion sacrificielle et s'appuyant sur la couche d'oxyde de grille de chaque côté du creux ; éliminer les première et seconde portions sacrificielles.

### Brève description des dessins

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 est une vue en perspective, précédemment décrite, d'un transistor MOS à grille déformable ;
les figures 2 et 3 sont des vues en coupe du transistor représenté en figure 1 dans deux états différents ;
la figure 4 est une vue en perspective d'un transistor MOS à grille déformable selon la présente invention ;
la figure 5 est une vue en coupe du transistor représenté en figure 4 ;
les figures 6 et 7 sont des vues en coupe du transistor représenté en figure 4 dans deux états différents ;
la figure 8 est un schéma d'un circuit oscillateur utilisant un transistor MOS à grille déformable selon la présente invention ; et
les figures 9A à 9D sont des vues en coupe de structures obtenues à l'issue d'étapes successives d'un procédé de fabrication d'un transistor à grille déformable selon la présente invention.

### Description détaillée

Par souci de clarté, de mêmes éléments ont été désignés par de mêmes références aux différentes figures et, de plus, comme cela est habituel dans la représentation des circuits intégrés, les figures 1, 2, 3, 4, 5, 6, 7 et 9A à 9D ne sont pas tracées à l'échelle.

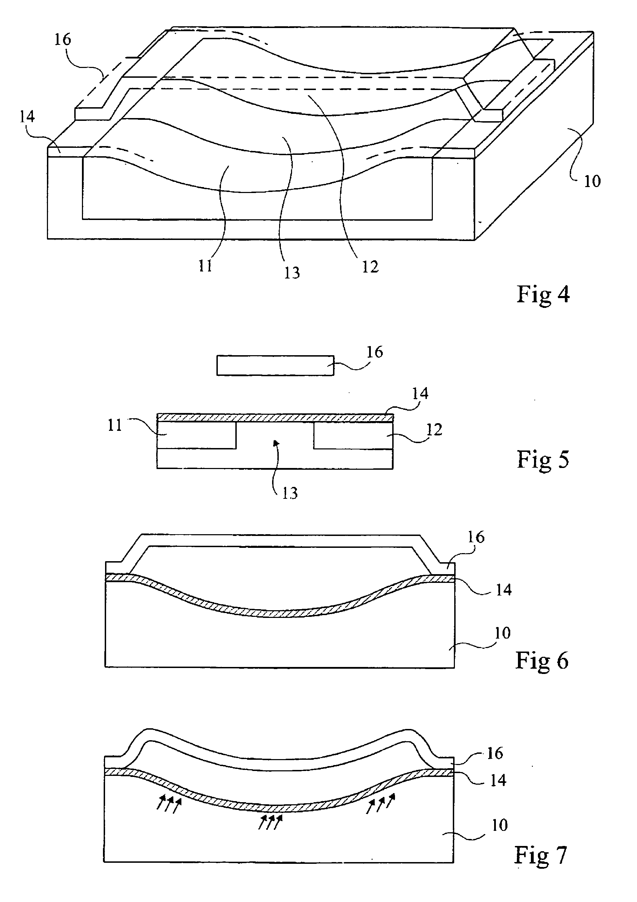

La figure 4 est une vue en perspective d'un transistor MOS à grille déformable selon la présente invention. Le transistor est formé dans un substrat semiconducteur 10. Deux zones de source/drain 11 et 12 séparées par une zone de canal 13 sont formées dans le substrat 10. Une fine couche d'oxyde de silicium 14, représentée partiellement, recouvre le substrat 10. La surface de la zone de canal 13 et des zones de source/drain 11 et 12 est courbe et forme un sillon. Une poutre de grille 16, représentée en pointillés, est placée au-dessus de la zone de canal 13 et s'appuie sur le substrat 10 de chaque côté du canal sur les bords du sillon.

Selon un aspect de la présente invention, la profondeur du sillon formé par la surface de la zone de canal augmente continûment des bords vers le fond du sillon, ou autrement dit des extrémités vers la partie centrale de la zone de canal.

Dans la suite de la description, on considérera, contrairement à l'usage, que la largeur de la zone de canal correspond à la distance séparant les zones de source/drain, la longueur de la zone de canal étant mesurée parallèlement aux surfaces de contact entre la zone de canal et les zones de source/drain. Par analogie, la longueur de la poutre sera prise parallèlement à la longueur de la zone de canal, et la largeur de la poutre parallèlement à la largeur de la zone de canal.

On notera que la largeur de la poutre peut être identique ou plus grande que celle de la zone de canal.

De plus, dans l'exemple de transistor représenté en figure 4, les zones de source/drain 11 et 12 ont une forme identique à celle de la zone de canal 13. Cependant, on notera que les zones de source/drain 11 et 12 peuvent avoir une forme différente. Seule la surface de la zone de canal 13 doit être courbe en forme de sillon.

A titre d'exemple non limitatif, les caractéristiques géométriques des éléments constitutifs du transistor représenté en figure 4 sont les suivantes :
Zone de canal,
   longueur : 5-50 µm
   largeur : 1-20 µm
Poutre de grille,
   longueur : 5-60 µm
   Largeur : 1-30 µm
Ecart maximal entre la poutre et la zone de canal : 100 nm à 1 µm.

La figure 5 est une vue en coupe du transistor représenté en figure 4 selon un plan perpendiculaire à l'axe longitudinal de la poutre de grille 16 et sensiblement au milieu de celle-ci. L'écart entre la poutre de grille 16 et la zone de canal 13 est susceptible de varier en fonction des forces appliquées sur la poutre de grille 16.

Les figures 6 et 7 sont des vues en coupe du transistor représenté en figure 4 prises selon l'axe longitudinal de la poutre de grille 16. Lorsqu'aucune force n'est appliquée sur la poutre de grille 16, la poutre est horizontale, comme cela est représenté en figure 6. Quand une force est appliquée sur la poutre 16, celle-ci se déforme et se rapproche de la zone de canal 13. Dans l'exemple représenté en figure 7, la déformation de la poutre est importante. La forme en sillon de la surface de la zone de canal 13 correspond sensiblement à la forme de la poutre 16 lorsque la déflexion de celle-ci est maximale. Grâce à cette courbure de la zone de canal, l'écart entre la poutre de grille 16 et la zone de canal 13 varie peu entre la partie centrale et les parties latérales de la zone de canal 13. En conséquence, le courant est sensiblement identique sur toute la longueur de la zone de canal. Ceci augmente la sensibilité du transistor.

Un avantage du transistor MOS à grille déformable selon la présente invention est qu'il détecte plus finement les mouvements de sa grille.

Un transistor MOS à grille déformable selon la présente invention peut être utilisé dans diverses applications. Un tel transistor peut être utilisé dans un dispositif tel qu'un accéléromètre ou encore constituer un élément d'un circuit tel qu'un circuit oscillateur comme cela est décrit ci-après.

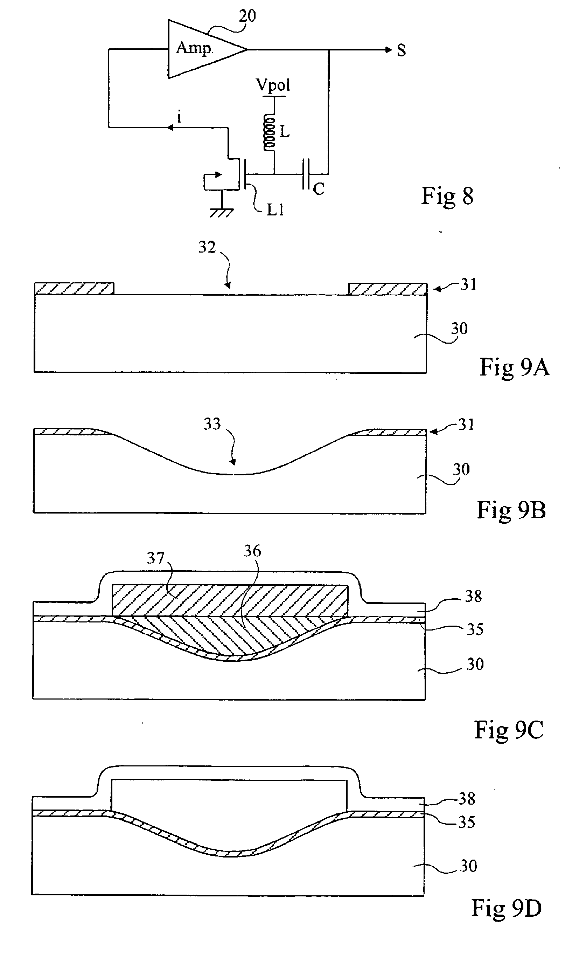

La figure 8 est un schéma d'un circuit oscillateur comprenant un transistor à grille déformable selon la présente invention. Ce circuit est constitué d'un amplificateur 20, d'un transistor à grille déformable 21 selon la présente invention, d'une bobine L et d'un condensateur C. La sortie de l'amplificateur 20, constituant la sortie S du circuit oscillateur, est reliée à la poutre de grille du transistor 21 par l'intermédiaire du condensateur C. La bobine L est placée entre une tension de polarisation Vpol et la poutre de grille du transistor 21. Le courant i traversant le transistor 21 est fourni en entrée de l'amplificateur 20. Le transistor est dans cet exemple de type NMOS, sa source et son substrat étant reliés à la masse, son drain étant relié à l'entrée de l'amplificateur 20.

La tension entre le substrat et la poutre de grille du transistor est égale à la tension Vpol qui est choisie relativement élevée de façon que la poutre soit fortement déformée. Le rôle du condensateur C est de filtrer les composantes continues de la tension délivrée par l'amplificateur 20. Les composantes alternatives de la tension délivrée par l'amplificateur 20 sont appliquées sur la poutre de grille du transistor. Le transistor fonctionne en résonateur. La poutre entre en résonance quand la tension appliquée sur celle-ci varie à une fréquence déterminée appelée ci-après fréquence de résonance fr. Quand la tension appliquée sur la poutre a une fréquence différente de fr, la poutre ne vibre quasiment pas. La fréquence fr dépend des caractéristiques géométriques de la poutre et de la tension de polarisation Vpol. Quand il est utilisé en résonateur, le transistor est équivalent à un filtre passe-bande.

Lorsque le circuit oscillateur est mis sous tension, il se met à osciller naturellement. La tension initialement fournie par l'amplificateur 20 est sensiblement nulle. Seul du bruit sort de l'amplificateur. Les composantes du bruit ayant une fréquence proche de la fréquence fr passent à travers le transistor fonctionnant en filtre. Un courant i variant à la fréquence fr est fourni à l'amplificateur qui délivre alors au transistor une tension variant à la fréquence fr. Après plusieurs boucles entre l'amplificateur et le transistor, le courant i, initialement de très faible amplitude, augmente progressivement jusqu'à atteindre une amplitude maximale. La tension fournie en sortie S a une amplitude fixée et varie à la fréquence de résonance fr.

Un transistor selon la présente invention peut être obtenu par divers procédés. Un exemple de procédé est décrit ci-après en relation aux figures 9A à 9D.

Dans une étape initiale, illustrée en figure 9A, on recouvre un substrat semiconducteur 30 d'une couche de protection 31 constituée par exemple de nitrure ou d'oxyde de silicium. On forme une ouverture 32 dans la couche de protection 31. L'ouverture peut avoir diverses formes en vue de dessus. Elle pourra par exemple être rectangulaire.

A l'étape suivante, illustrée en figure 9B, on effectue un polissage mécano-chimique de la structure précédemment formée en choisissant un produit de gravure attaquant préférentiellement le substrat semiconducteur 30 plutôt que la couche de protection 31. Lorsque l'ouverture 32 est suffisamment grande, il se forme un creux 33 en forme de "cuvette" dans le substrat 30 sous l'ouverture 32. On élimine ensuite la couche de protection 31.

Des zones de source/drain sont formées par implantation ionique à l'issue de cette étape ou éventuellement préalablement la formation de la cuvette 32.

A l'étape suivante, illustrée en figure 9C, on fait croître une fine couche 35 d'oxyde de grille sur le substrat 30.

On dépose ensuite une première couche sacrificielle sur l'ensemble de la structure précédemment obtenue puis on effectue un polissage mécano-chimique de cette couche sacrificielle jusqu'à découvrir les parties de la couche d'oxyde de grille 35 entourant le creux 33. Le creux 33 est alors rempli d'une première portion sacrificielle 36.

On dépose de nouveau une couche sacrificielle que l'on grave de façon à conserver une seconde portion sacrificielle 37 placée au-dessus de la première portion sacrificielle 36.

On forme ensuite une poutre de grille 38 au-dessus de la portion sacrificielle 37, la poutre s'appuyant sur la couche d'oxyde de grille 35 de chaque côté de la portion sacrificielle 37. Cette poutre de grille peut être classiquement obtenue par un dépôt puis une gravure d'une ou de plusieurs couches de matériaux. La poutre est par exemple constituée de silicium polycristallin de préférence dopé ou d'un tricouche de métal/titane/nitrure de silicium. La largeur de la poutre est prévue inférieure à celle du creux de façon que la portion sacrificielle 37 soit visible de chaque côté de la poutre de grille 38.

A l'étape suivante, illustrée en figure 9D, on élimine les portions sacrificielles 36 et 37, par exemple par gravure.

## Revendications

1. Transistor MOS à grille déformable formé dans un substrat semiconducteur (10), comprenant des zones de source et de drain (11, 12) séparées par une zone de canal (13) s'étendant dans une première direction de la source au drain et dans une deuxième direction perpendiculaire à la première, une poutre conductrice de grille (16) placée au moins au-dessus de la zone de canal s'étendant dans la deuxième direction entre des points d'appui placés sur le substrat de chaque côté de la zone de canal, **caractérisé en ce que** la surface de la zone de canal est creuse et a une forme semblable à celle de la poutre de grille lorsque celle-ci est en déflexion maximale vers la zone de canal.

2. Transistor selon la revendication 1, comprenant en outre une couche d'oxyde de grille (14) recouvrant la zone de canal (13).

3. Transistor selon la revendication 1, dans lequel la poutre (16) est en silicium polycristallin dopé.

4. Transistor selon la revendication 1, dans lequel la poutre (16) est un tricouche de métal, de titane et de nitrure de silicium.

5. Transistor selon la revendication 1, dans lequel les zones de source et de drain (11, 12) ont une forme courbe identique à celle de la zone de canal (13).

6. Circuit oscillateur comprenant un transistor à grille déformable (21) selon la revendication 1, le transistor étant traversé par un courant qui est fourni à un amplificateur (20), la sortie de l'amplificateur correspondant à la sortie du circuit étant reliée à la poutre de grille du transistor par l'intermédiaire d'un condensateur (C), la poutre de grille étant reliée à une tension de polarisation (Vpol).

7. Procédé de fabrication d'un transistor à grille déformable comprenant les étapes suivantes :
former par implantation dans un substrat (30) des zones de source et de drain séparées par une zone de canal ;
déposer une couche de protection (31) sur le substrat ;
former une ouverture (32) dans la couche de protection au moins au-dessus de la zone de canal ;
effectuer un polissage mécano-chimique de la structure précédemment obtenue, le procédé de gravure du polissage étant tel qu'il grave davantage le substrat que la couche de protection, d'où il résulte qu'un creux (33) est formé dans le substrat sous ladite ouverture ;
éliminer la couche de protection ;
former une couche d'oxyde de grille sur le substrat ;
former une première portion sacrificielle (36) dans ledit creux ;
déposer et graver une couche sacrificielle d'où il résulte qu'une deuxième portion sacrificielle recouvre la première portion sacrificielle ;
former une poutre conductrice de grille (37) passant au-dessus de la seconde portion sacrificielle et s'appuyant sur la couche d'oxyde de grille de chaque côté du creux ;
éliminer les première et seconde portions sacrificielles.

## Claims

1. A MOS transistor with a deformable gate formed in a semiconductor substrate (10), comprising source and drain areas (11, 12) separated by a channel area (13) extending in a first direction from the source to the drain and in a second direction perpendicular to the first one, a conductive gate beam (16) placed at least above the channel area extending in the second direction between bearing points placed on the substrate on each side of the channel area, **characterized in that** the surface of the channel area is hollow and has a shape similar to that of the gate beam when said beam is in maximum deflection towards the channel area.

2. The transistor of claim 1, further comprising a gate oxide layer (14) covering the channel area (13).

3. The transistor of claim 1, wherein the beam (16) is made of doped polysilicon.

4. The transistor of claim 1, wherein the beam (16) is a metal, titanium, and silicon nitride tri-layer.

5. The transistor of claim 1, wherein the source and drain areas (11, 12) have a curved shape identical to that of the channel area (13).

6. An oscillating circuit comprising the transistor with a deformable gate (21) of claim 1, the transistor conducting a current which is provided to an amplifier (20), the amplifier output corresponding to the circuit output being connected to the gate beam of the transistor via a capacitor (C), the gate beam being connected to a bias voltage (Vpol).

7. A method for manufacturing a transistor with a deformable gate comprising the steps of:
forming by implantation in a substrate (30) source and drain areas separated by a channel area;
depositing a protection layer (31) on the substrate;
forming an opening (32) in the protection layer at least above the channel area;
performing a chem.-mech. polishing of the previously-obtained structure, the etch method of the polishing being such that it etches the substrate more than the protection layer, whereby a recess (33) is formed in the substrate under said opening;
eliminating the protection layer;
forming a gate oxide layer on the substrate;
forming a first sacrificial portion (36) in said recess;
depositing and etching a sacrificial layer, whereby a second sacrificial portion covers the first sacrificial portion;
forming a conductive gate beam (37) running above the second sacrificial portion and bearing on the gate oxide layer on each side of the recess;
eliminating the first and second sacrificial portions.

## Patentansprüche

1. In einem Halbleitersubstrat (10) ausgebildeter MOS-Transistor mit verformbarem Gate, welcher Source- und Drainzonen (11, 12) umfasst, die durch eine sich in einer ersten Richtung von der Source- zur Drainzone und in einer hierzu rechtwinkligen zweiten Richtung erstreckende Kanalzone (13) getrennt sind, sowie ein Gate (16) in Form eines leitenden Balkens, der wenigstens über der sich in der zweiten Richtung erstreckenden Kanalzone zwischen auf dem Substrat zu beiden Seiten der Kanalzone befindlichen Stütz- bzw. Auflagepunkten angeordnet ist, **dadurch gekennzeichnet, dass** die Oberfläche der Kanalzone eine hohle Vertiefung bzw. Mulde aufweist und eine Form ähnlicher Art wie der Gate-Leiterbalken besitzt, wenn dieser sich in maximaler Auslenkung in Richtung hin zur Kanalzone befindet.

2. Transistor nach Anspruch 1, der des weiteren eine die Kanalzone (13) bedeckende Gate- Oxydschicht (14) aufweist.

3. Transistor nach Anspruch 1, bei welchem der Balken (16) aus dotiertem polykristallinem Silizium besteht.

4. Transistor nach Anspruch 1, bei welchem der Balken (16) ein Dreischichtgebilde aus Metall, Titan und Siliziumnitrid ist.

5. Transistor nach Anspruch 1, bei welchem die Source- und die Drainzone (11, 12) eine bogenförmig gekrümmte Form gleicher Art wie die Kanalzone (13) besitzt.

6. Oszillatorschaltung mit einem Transistor mit verformbarem Gate (21) nach Anspruch 1, wobei der Transistor von einem Strom durchsetzt wird, der einem Verstärker (20) zugeführt wird, dessen Ausgang dem Ausgang der Schaltung entspricht und mit dem Gate- Balken des Transistors über einen Kondensator (C) verbunden ist, wobei der Gate-Balken mit einer Vorspannungsquelle (Vpo1) verbunden ist.

7. Verfahren zur Herstellung eines Transistors mit verformbarem Gate, umfassend die folgenden Schritte bzw. Stufen:
in einem Substrat (30) werden mittels Implantation durch eine Kanalzone getrennte Source- und Drainbereiche ausgebildet;
auf dem Substart wird eine Schutzschicht (31) abgeschieden;
in der Schutzschicht wird wenigstens über der Kanalzone eine Öffnung bzw. Ausnehmung (32) gebildet;
das vorstehend erhaltene Gebilde wird einem mechanisch-chemi - schen Poliervorgang unterworfen, wobei das Polier- Ätzverfahren solcher Art ist, dass es mehr das Substrat als die Schutzschicht ätzt, mit dem Ergebnis, dass in dem Substart unter der genannten Öffnung eine Vertiefung bzw. Mulde (33) gebildet wird;
die Schutzschicht wird entfernt;
auf dem Substrat wird eine Gate- Oxydschicht gebildet;
in der genannten Vertiefung bzw. Mulde wird ein erster opferbarer Bereich (36) gebildet;
Abscheiden und Ätzen einer opferbaren Schicht, mit dem Ergebnis, dass ein zweiter opferbarer Bereich den ersten opferbaren Bereich bedeckt;
Bilden eines als Gate dienenden Leiterbalkens (37), der über den zweiten opferbaren Bereich führt und sich auf der Gate-Oxydschicht zu beiden Seiten der Vertiefung bzw. Mulde abstützt;
der erste und der zweite Opferbereich werden entfernt
